# EUROPEAN PATENT APPLICATION

(11) **EP 2 009 675 A1**
(43) Date of publication of application: **31.12.2008**
(21) Application number: 08158483.1
(22) Date of filing: 18.06.2008
(51) Int. Cl.: H01L 21/00

(54) **Manufacturing apparatus installing method and model**

(30) Priority: 27.06.2007 JP 2007169489
(71) Applicant: Canon Kabushiki Kaisha, Tokyo 146-8501 (JP)
(72) Inventor: Yamazaki, Toshiaki, Tokyo 146-8501 (JP)
(74) Representative: TBK-Patent

(57) **Abstract**

This invention discloses an installing method of installing a manufacturing apparatus formed by connecting a plurality of units via a line. The installing method includes the steps of arranging each of a plurality of models at a prospective installation position of a corresponding unit of the plurality of units, each of the plurality of models having a connection to the line, which is provided at the same position as in the corresponding unit of the plurality of units, laying the line and connecting the line to the plurality of models, inspecting the lines in a state that the line is connected to the plurality of models, installing the plurality of units in place of the plurality of models, and connecting the line to the plurality of units.

## Description

### BACKGROUND OF THE INVENTION

### Field of the Invention

The present invention relates to an installing method of installing a manufacturing apparatus and a model suitable for the method.

### Description of the Related Art

When installing a semiconductor manufacturing apparatus in a semiconductor manufacturing plant, a plurality of lines connected to plant facilities are connected to the semiconductor manufacturing apparatus to supply utilities to it. The utilities indicate, for example, power, gases, compressed air, exhaust, and cooling water necessary for manufacturing a product.

Conventionally, a semiconductor manufacturing apparatus is installed in a semiconductor manufacturing plant in accordance with the following procedure. First, utility lines are laid. Next, the semiconductor manufacturing apparatus is brought into the clean room of the semiconductor plant and installed there. Finally, the utility lines are connected to the semiconductor manufacturing apparatus.

A semiconductor manufacturing apparatus maker is required to complete start-up and delivery of a semiconductor manufacturing apparatus in a short period of time after it has been brought into a semiconductor plant. However, since a semiconductor manufacturing apparatus is recently becoming more precise, complex, and multifunctional, necessary utilities are increasing. For this reason, the utility line connection work tends to require a longer period of time.

To solve this problem, the following installation procedure has been known. First, an apparatus model is prepared. The model has almost the same outer dimensions and the same connection specifications (connection components and connection positions) to the utility lines as a semiconductor manufacturing apparatus. Next, the apparatus model is temporarily placed at the installation position of the semiconductor manufacturing apparatus. Utility lines are laid to the vicinity of the connections of the apparatus model and temporarily connected to the apparatus model. The utility lines temporarily connected to the apparatus model are disconnected, and the apparatus model is removed. Then, the semiconductor manufacturing apparatus is installed at the position where the apparatus model was temporarily placed. The utility lines which were temporarily connected to the apparatus model are finally connected to the semiconductor manufacturing apparatus.

According to the above-described installation procedure, the utility line connection work which is usually carried on after bringing-in and installation of the semiconductor manufacturing apparatus can be done before bringing-in. This shortens the time that the maker which conducts the utility line connection work waits for bringing-in and installation of the apparatus. The maker can make good use of the time from bringing-in to delivery of the apparatus. It is therefore possible to deliver the apparatus to the semiconductor manufacturing plant side in a short time.

A recent highly precise, complex, and multifunctional semiconductor manufacturing apparatus has a large scale in itself. Similarly, an exposure apparatus also has a large-scale main body unit. In addition to the main body unit, electrical units, air conditioning units, and units associated with compressed air, liquids, and gases are also increasing in their scales.

To raise the productivity of a semiconductor manufacturing plant by minimizing the occupied space of a single apparatus in the clean room (main manufacturing floor), only the main body unit is arranged in the clean room (main manufacturing floor) in many cases. In this case, the electrical units, air conditioning units, and units associated with compressed air, liquids, and gases except the main body unit can be arranged in the space of a utility floor that is located under the clean room (main manufacturing floor).

Hence, many cables, tubes, and ducts can be arranged between the main body unit located in the clean room (main manufacturing floor) and the units other than the main body unit which are located on the utility floor. There are also cables that connect the units on the utility floor to each other. The units on the utility floor are also connected to the plant facilities. For these reasons, the semiconductor manufacturing apparatus installation period tends to be long.

As for, for example, the cables, since cable laying between the clean room (main manufacturing floor) and the utility floor is a work on a large scale, the cables may be damaged during the cable laying.

The cable length is preferably as short as possible because it is limited from the viewpoint of, for example, noise resistance and voltage drop. The layout of the electrical units, air conditioning units, and units associated with compressed air, liquids, and gases should be determined such that the cable length can be minimized as much as possible. When a longer cable is prepared, how to treat the extra length must be examined. In the semiconductor manufacturing plant, it may be impossible to ensure a sufficient space for the extra length treatment.

Hence, the cable length needs to be set optimally for each apparatus. That is, cable length calculation is important. An error in cable locating at the time of cable laying may make it unable to connect the cable to a connection of an apparatus. The laying work therefore requires great care and a long time.

It is preferable to make an inspection (e.g., check disconnection) of a laid cable before the semiconductor manufacturing apparatus is brought into the plant. If a problem is found, a new cable is preferably laid. Even for tubes and ducts, it is preferable to make an inspection after laying and, if there is a problem, take a measure before bringing-in of the semiconductor manufacturing apparatus.

The above-described problems are not limited to installation of a semiconductor manufacturing apparatus but apply to any manufacturing apparatus.

### SUMMARY OF THE INVENTION

The present invention provides an improvement in the efficiency of an installing operation of, for example, a manufacturing apparatus.

The present invention in its first aspect provides an installing method as specified in claims 1 to 8.

The present invention in its second aspect provides a model as specified in claim 9.

According to the present invention, it is possible to increase the efficiency of an installing operation of, for example, a manufacturing apparatus.

Further features of the present invention will become apparent from the following description of exemplary embodiments with reference to the attached drawings.

### BRIEF DESCRIPTION OF THE DRAWINGS

Fig. 1 is a view schematically showing a manufacturing apparatus (exposure apparatus) installed in a semiconductor manufacturing plant;

Fig. 2 is a flowchart illustrating a manufacturing apparatus (exposure apparatus) installing method according to a preferred embodiment of the present invention;

Fig. 3 is a view schematically showing a halfway step in a manufacturing apparatus (exposure apparatus) installing operation;

Fig. 4 is a view schematically showing a halfway step in the manufacturing apparatus (exposure apparatus) installing operation;

Fig. 5 is a view schematically showing a halfway step in the manufacturing apparatus (exposure apparatus) installing operation; and

Fig. 6 is a view schematically showing an arrangement example of a model.

### DESCRIPTION OF THE EMBODIMENTS

A preferred embodiment of the present invention will now be described with reference to the accompanying drawings.

Installation of a manufacturing apparatus (exposure apparatus) for a device such as a semiconductor device will be exemplified below. However, the present invention is useful for installation of any manufacturing apparatus.

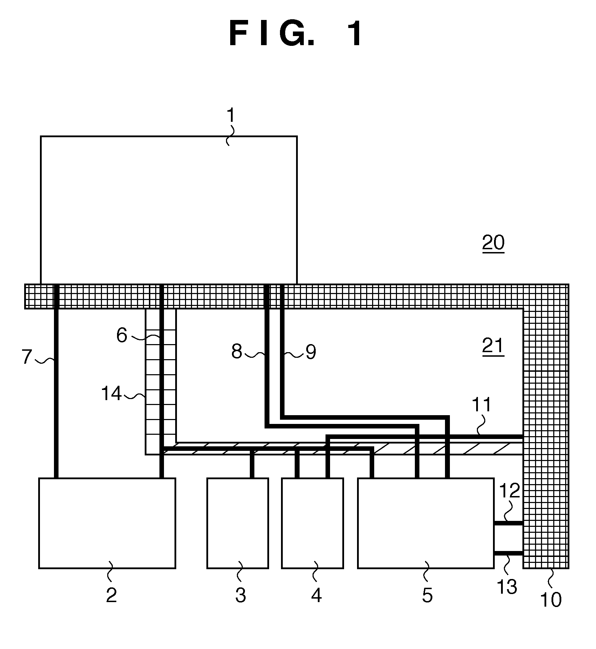

Fig. 1 is a view schematically showing a manufacturing apparatus (exposure apparatus) installed in a semiconductor manufacturing plant. The exposure apparatus can be used in a lithography process of manufacturing a device such as a semiconductor device, as is well known.

A main body unit 1 of the exposure apparatus can be arranged in a clean room (main manufacturing floor). The main body unit 1 can include, for example, an original (reticle) stage mechanism for aligning an original (reticle), an illumination optical system for illuminating the original, a projection optical system for projecting the pattern of the original onto a substrate, and a substrate (wafer) stage mechanism for aligning the substrate.

Of the plurality of units included in the exposure apparatus, examples of units except the main body unit 1 are a light source unit (e.g., laser unit) 2, electrical units 3 and 4, and air conditioning/liquid cooling unit 5. The light source unit 2, electrical units 3 and 4, and air conditioning/liquid cooling unit 5 can be arranged on a utility floor 21 which is different from a main manufacturing floor 20 where the clean room is arranged. The light source unit 2, electrical units 3 and 4, and air conditioning/liquid cooling unit 5 can be connected to each other via a cable 6.

The main body unit 1 and the light source unit 2 are connected via a tube 7 which supplies light from the light source unit 2 to the main body unit 1. The main body unit 1 and the air conditioning/liquid cooling unit 5 are connected via a tube 8 which circulates a liquid (coolant) for air conditioning and a duct 9 which supplies/exhausts air for air conditioning.

Plant facilities 10 supply utilities to the units 1, 2, 3, 4, and 5 included in the exposure apparatus. The utilities indicate, for example, power, gases, exhaust, compressed air, and cooling water. The electrical unit 4 is connected to the plant facilities 10 via a cable 11. The air conditioning/liquid cooling unit 5 is connected to the plant facilities 10 via a tube 12 and a duct 13. A cable tray 14 fixes the cables 6 and 11.

In this specification, the components such as cables, tubes, and ducts for connecting the units to each other or the units to the plant facilities will be collectively called "lines". In the example shown in Fig. 1, the lines include the cables 6 and 11, the tubes 7, 8, and 12, and the ducts 9 and 13.

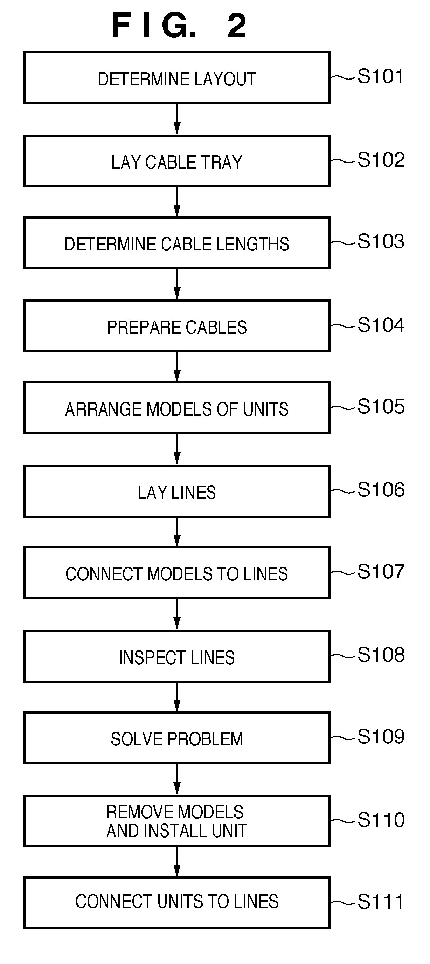

Fig. 2 is a flowchart illustrating a manufacturing apparatus (exposure apparatus) installing method according to a preferred embodiment of the present invention. In step S101, the layout of the main body unit 1 of the exposure apparatus in the clean room formed on the main manufacturing floor 20 and the layout of the light source unit 2, electrical units 3 and 4, and air conditioning/liquid cooling unit 5 on the utility floor 21 under the clean room are determined. In step S101, the layout of the lines, that is, the cables 6 and 11, the tubes 7, 8, and 12, and the ducts 9 and 13 is also determined. Considering noise resistance and voltage drop, the layout of the units 2 to 5 should be determined such that the lengths of the cables 6 and 11 can be minimized as much as possible.

In step S102, the cable tray 14 is laid in the semiconductor manufacturing plant.

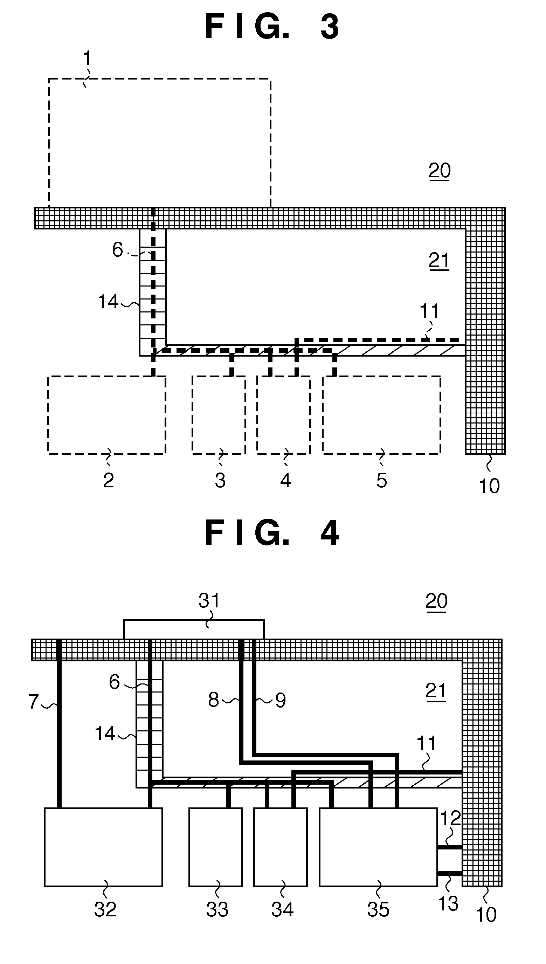

In step S103, the length of each cable to be laid is determined. This determination is done by actually measuring the lengths of the cables to be laid along the cable tray 14 laid in in the semiconductor manufacturing plant, as schematically shown in Fig. 3, or inputting the data of the cable tray to the design CAD of the semiconductor manufacturing plant and executing calculation on the CAD.

The length of a cable should be as short as possible in consideration of noise resistance and voltage drop. When a longer cable is prepared, how to treat the extra length must be examined. In the semiconductor manufacturing plant, it may be impossible to ensure a sufficient space for the extra length treatment. It is therefore necessary to determine the cable length at an appropriate accuracy.

In step S104, the cables 6 and 11 having connectors and lengths determined in step S103 are prepared.

In step S105, models 31 to 35 corresponding to the units 1 to 5, respectively, are arranged in the semiconductor manufacturing plant, as schematically shown in Fig. 4. The models 31 to 35 of the units 1 to 5 are arranged at the prospective installation positions of the units 1 to 5. The models 31 to 35 have connections to be connected at least some of the plurality of lines. The connections are provided at the same positions as those of the corresponding units. The connections provided on the models 31 to 35 are designed to be connectable to the lines to be connected to the connections of the units 1 to 5 corresponding to the models 31 to 35. The models 31 to 35 have an inspection function of inspecting the lines connected to the connections.

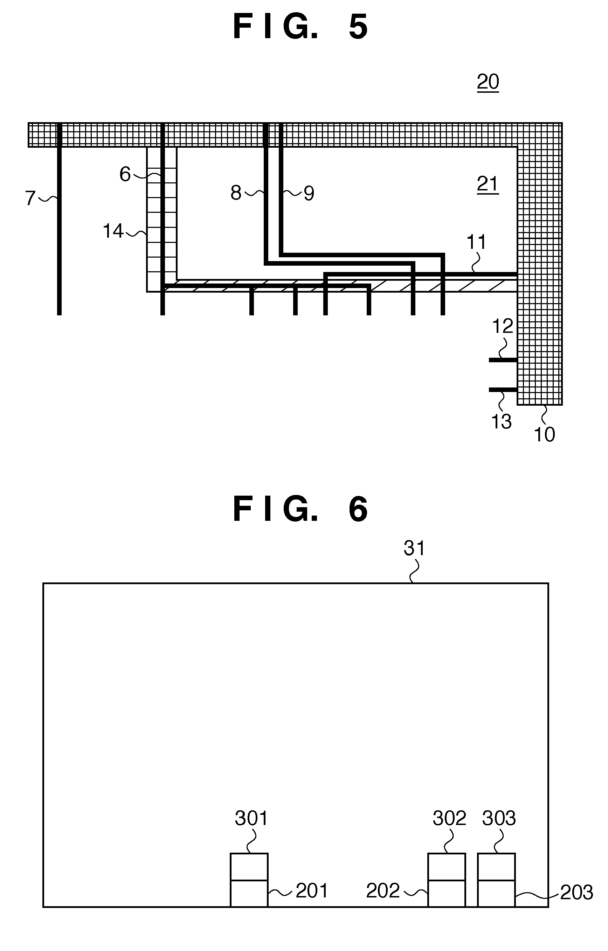

Fig. 6 is a view schematically showing the model 31 of the main body unit 1. The model 31 has connections 201 to 203 to be connected to the lines. More specifically, the model 31 has the connections 201, 202, and 203 to be connected to the cable 6, the tube 8, and the duct 9, respectively. In the examples shown in Figs. 4 and 6, the model 31 has no connection to be connected to the tube 7 which connects the light source unit 2 to the main body unit 1. This is because the tube 7 is not included in the connection inspection targets. When the tube 7 is included in the connection inspection targets, the model 31 has a connection to be connected to the tube 7.

The model 31 also has inspectors to inspect at least some of the lines to be connected to it. More specifically, the model 31 has an inspector 301 for inspecting the cable 6 connected to the connection 201, an inspector 302 for inspecting the tube 8 connected to the connection 202, and an inspector 303 for inspecting the duct 9 connected to the connection 203. Note that the models 32 to 35 can also have inspectors to inspect the lines, like the model 31.

In step S106, the lines are laid in the semiconductor manufacturing plant, as schematically shown in Fig. 4. More specifically, the cables 6 and 11 are laid in the cable tray 14. The cables between the clean room formed on the main manufacturing floor 20 and the utility floor 21 under it are generally laid by feeding the cables from the upper main manufacturing floor 20 to the lower utility floor 21. In this embodiment, the model 31 of the main body unit 1 is arranged in the clean room on the main manufacturing floor 20 in advance. Hence, the cable 6 can easily be located by connecting the connector of the cable 6 to the connection 201 of the model 31. In step S106, the remaining lines, that is, the tubes 7, 8, and 12 and the ducts 9 and 13 are also arranged.

In laying the lines in step S106, the lines and the connections of the model 31 of the main body unit 1 can be connected first for locating the lines.

In step S107, the laid cables 6 and 11, tubes 7, 8, and 12, and ducts 9 and 13 are connected to the connections of the corresponding models.

In step S108, the inspectors 301 to 303 provided on the model 31 and the inspectors provided on the models 32 to 35 inspect the lines, that is, the cables 6 and 11, tubes 8 and 12, and ducts 9 and 13. This inspection can include, for example, inspection of disconnections in the cables and inspection of gas or liquid leakage from the tubes. For example, a disconnection may occur in laying the cables 6 and 11 in the cable tray 14. Hence, this inspection is important.

Additionally, measurement of electromagnetic noise around the laid cables 6 and 11 and measurement and inspection of long-term stability or short-term change in the utilities (e.g., air pressure, cooling water temperature, and power quality) are possible.

In step S109, a problem detected in the inspection in step S108 is solved. For example, if a disconnection is detected in a cable, the cable is exchanged with a new one.

In step S110, the models 31 to 35 are removed, as schematically shown in Fig. 5. Instead, the units 1 to 5 are installed at their prospective arrangement positions, as schematically shown in Fig. 1.

In step S111, the lines, that is, the cables 6 and 11, the tubes 7, 8, and 12, and the ducts 9 and 13 are connected to the connections of the corresponding units. With the above-described steps, installation of the exposure apparatus in the semiconductor manufacturing plant is completed.

The above-described installing method is applicable to installation of semiconductor manufacturing apparatuses other than the exposure apparatus and to installation of a manufacturing apparatus for manufacturing a device or any articles other than the semiconductor device.

According to the preferred embodiment of the present invention, it is possible to arrange a model of a unit included in a manufacturing apparatus and locate a line using the model before the manufacturing apparatus is installed in a plant. This allows making the line arrangement work efficiently. Additionally, inspecting a line that is connected to a model makes it possible to efficiently find a problem in the line. The line can be prepared before bringing-in of the manufacturing apparatus into the plant. This shortens the time required from bringing-in of the manufacturing apparatus into the plant to start-up of the apparatus.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.
This invention discloses an installing method of installing a manufacturing apparatus formed by connecting a plurality of units via a line. The installing method includes the steps of arranging each of a plurality of models at a prospective installation position of a corresponding unit of the plurality of units, each of the plurality of models having a connection to the line, which is provided at the same position as in the corresponding unit of the plurality of units, laying the line and connecting the line to the plurality of models, inspecting the lines in a state that the line is connected to the plurality of models, installing the plurality of units in place of the plurality of models, and connecting the line to the plurality of units.

## Claims

1. An installing method of installing a manufacturing apparatus formed by connecting a plurality of units via a line, comprising the steps of:
arranging each of a plurality of models at a prospective installation position of a corresponding unit of the plurality of units, each of the plurality of models having a connection to the line, which is provided at the same position as in the corresponding unit of the plurality of units;
laying the line and connecting the line to the plurality of models;
inspecting the line in a state that the line is connected to the plurality of models;
installing the plurality of units in place of the plurality of models; and
connecting the line to the plurality of units.

2. The method according to claim 1, further comprising solving a problem found by the inspection.

3. The method according to claim 1, wherein the line includes at least one of a cable, a tube, and a duct.

4. The method according to claim 1, wherein at least some of the plurality of units have an inspector for the inspection.

5. The method according to claim 4, wherein the inspection includes at least one of inspection of a disconnection in a cable, inspection of leakage from a tube, inspection of electromagnetic noise around a cable, and utility inspection.

6. The method according to claim 5, wherein the utility inspection includes at least one of inspection of air pressure, inspection of cooling water temperature, and inspection of power quality.

7. The method according to claim 1, wherein the plurality of units include a main body unit and a light source unit which are included in an exposure apparatus.

8. The method according to claim 5, wherein the main body unit is arranged in a clean room, and the light source unit is arranged on a floor different from a floor where the clean room is arranged.

9. A model of one unit of a plurality of units in a manufacturing apparatus formed by connecting the plurality of units via a line, comprising:
a connection to be connected to the line; and
an inspector which inspects the line connected to the connection,
wherein said connection is provided at the same position as that of a connection of said one unit.
